# EUROPÄISCHE PATENTSCHRIFT

(11) **EP 1 747 594 B1**
(45) Veröffentlichungstag und Bekanntmachung des Hinweises auf die Patenterteilung: **16.01.2013**
(21) Anmeldenummer: 05743098.5
(22) Anmeldetag: 13.05.2005
(51) Int. Cl.: H01L 41/09, H02N 2/00

(54) **PIEZOELEKTRISCHER ULTRASCHALLMOTOR**
PIEZOELECTRIC ULTRASOUND MOTOR
MOTEUR A ULTRASONS PIEZO-ELECTRIQUE

(30) Priorität: 18.05.2004 DE 102004024656
(43) Veröffentlichungstag der Anmeldung: 31.01.2007
(73) Patentinhaber: Physik Instrumente (PI) GmbH & Co. KG, 76228 Karlsruhe (DE)
(72) Erfinder: WISCHNEWSKIJ, Wladimir, 76337 Waldbronn (DE); VYSHNEVSKYY, Oleksiy, 76744 Woerth (DE)
(74) Vertreter: Kruspig, Volkmar
(86) Internationale Anmeldenummer: PCT/EP2005/005287
(87) Internationale Veröffentlichungsnummer: WO 2005/114760

(56) Entgegenhaltungen:
- EP-A- 1 267 425
- WO-A-99/31740
- WISCHNEWSKIY W ET AL: "New ultrasonic piezoelectric actuator for nanopositioning" ACTUATOR 2004, 9TH INTERNATIONAL CONFERENCE ON NEW ACTUATORS, BREMEN, GERMANY, 14. Juni 2004 (2004-06-14), Seiten 118-122, XP009054063
- SNITKA V: "Stepping ultrasonic motors for precision positioning" PROCEEDINGS IEEE 1993 ULTRASONICS SYMPOSIUM, BALTIMORE, MD, USA, 31. Oktober 1993 (1993-10-31), Seiten 449-452, XP010114997 ISBN: 0-7803-1278-3

## Beschreibung

Die Erfindung betrifft lineare sowie rotatorische piezoelektrische Ultraschallmotoren. Die Erfindung kann als ein elektrischer Motor in üblichen Positionierungssystemen der Gerätetechnik sowie in Systemen der Feinpositionierung eingesetzt werden.

Aus der US-PS 5,672,930 sind piezoelektrische Ultraschallmotoren mit einem metallischen Resonator bekannt, an den piezoelektrische Elemente angeklebt sind. Nachteilig erweist sich bei diesen Motoren die Tatsache, dass aufgrund unterschiedlicher thermischer Ausdehnungskoeffizienten des metallischen Resonators einerseits und der piezoelektrischen Elemente andererseits es unmöglich ist, mit diesen Motoren große mechanische Leistungen zu erreichen. Außerdem ist der metallische Resonator ein passiver Körper. Um große Bewegungsgeschwindigkeiten des zu bewegenden Elementes zu erreichen, ist es erforderlich die piezoelektrische Elemente mit relativ hohen elektrischen Spannungen anzuregen. Diese Nachteile verringern die Zuverlässigkeit des Motorbetriebs und begrenzen somit Einsatigebiete für solche Motoren.

Außer den erwähnten piezoelektrischen Motoren sind vor allem piezoelektrische Ultraschallmotoren mit einem akustischen Resonator in Form einer monolithischen piezokeramischen Platte bekannt, an derer kleinen Stirnseite ein Stoßelement angeordnet ist. Verwiesen wird hier z.B. auf US-PS 5,453,653 oder US-PS 5,616,980. An großen Oberflächen der piezokeramischen Platte sind Generatoren akustischer Stehwellen angeordnet, die gleichzeitig eine stehende Biege- und eine Longitudinalwelle anregen. Als Ergebnis der Superposition der beiden Wellen erfährt das Stoßelement eine elliptische Bewegung, womit dem zu bewegenden Elementen die Bewegungsenergie verliehen wird.

Nachteilig erweist sich bei den Motoren dieser Art die Tatsache, dass als die energieübertragende Welle die Biegewelle eingesetzt wird, die mit den Generatoren einen geringen elektromechanischen Kopplungsfaktor aufweist. Ein geringer Kopplungsfaktor führt zur erheblichen Erhöhung der elektrischen Anregungsspannung des Resonators, zur Effektivitätsverringerung der Motoren sowie zur Begrenzung ihrer Leistung. Bei solchen Motoren ist es nicht möglich, durch eine Vergrößerung des Resonators die mechanische Leistung der Motoren zu erhöhen. Bei einer Längenvergrößerung der piezokeramischen Platte wird die Resonanzfrequenz des Resonators immer kleiner, was eine Verringerung seiner spezifischen Leistung als Folge hat. Beispielsweise haben die nach diesem Prinzip aufgebaute Standard-Ultraschallmotoren der Firma Nanomotion mit nur einer piezokeramischen Platte als Resonator eine mechanische Leistung von ca. 0,4W. Zu ihrer Erhöhung werden bis zu acht solcher Piezoaktoren in einem Gehäuse angeordnet (siehe Firmenbroschüre unter http://www.nanomotion.com/In2000index.html). Diese Maßnahme verkompliziert und verteuert die gesamte Konstruktion der Antriebe und verringert ihre Zuverlässigkeit.

Weiterhin weisen derartige Motoren ein kompliziertes System der Anregungselektroden auf, welches eine elektrische Verbindung mit Hilfe von kreuzweise-diagonal angelöteten Leitern erfordert. Dies verringert zusätzlich die Zuverlässigkeit der Motoren, da beim Einwirken von Ultraschall oft ein Abreißen der Leitungen von der piezoelektrischen Platte die Folge ist.

Als ein weiterer Nachteil ist die ungünstige konstruktive Handhabung derartiger Motoren zu nennen. Die Längsachse des Resonators bzw. der Aktor muss senkrecht zu dem zu bewegenden Element angeordnet werden. Diese Anordnung führt zur Vergrößerung der Antriebssysteme, in denen die Motoren eingesetzt werden, und macht ihre konstruktive Handhabung kompliziert.

EP 1 267 425 A2 offenbart einen piezoelektrischen Ultraschallmotor, bei dem ein plattenförmiger piezoelektrischer Oszillator zu stehenden longitudinalen akustischen Wellen gleicher Resonanzfrequenz in Richtung seiner Länge sowie seiner Höhe angeregt wird, wobei die Länge einem ganzzahligen Vielfachen der Wellenlänge gleich ist und die Höhe gleich einer halben Wellenlänge ist. Die Überlagerung der Wellen führt zu symmetrischen Deformationen der Platte, wodurch sich Punkte an den Stirnseiten längs elliptischer Bahnen bewegen. Ein dort angebrachtes Friktionselement treibt ein angepresstes Element an.

Aufgabe der Erfindung ist es daher, alle erwähnten Nachteile der angeführten Motoren zu beseitigen und gleichzeitig eine Verringerung der Anregungsspannung der Motoren, eine Erhöhung der mechanischen Leistung, der Zuverlässigkeit, eine Vereinfachung der Motorkonstruktion, eine Verringerung der Herstellungskosten, sowie eine Verbesserung der konstruktiven Handhabung der Motoren zu erreichen.

Die gestellte Aufgabe wird durch einen piezoelektrischen Ultraschallmotor gemäß Anspruch 1 gelöst. Dabei wird im piezoelektrischen Ultraschallmotor ein Oszillator in Form einer piezoelektrischen Platte mit der Länge L und mit der Höhe H sowie mit einem oder zwei am Oszillator angeordneten und elastisch an die Friktionsoberfläche des zu bewegenden Teils angepreßten Friktionselemente, die erwähnte piezoelektrische Platte durch eine senkrecht zu großen Oberflächen verlaufende Trennebene in zwei gleiche Teile geteilt, wobei mindestens eine von diesen Teilen einen unsymmetrischen Generator unsymmetrischer akustischer Stehwelle beinhaltet, der bei seiner Ansteuerung eine unsymmetrische zweidimensionale stehende Welle erzeugt, so dass die in der Mitte der langen Stirnseiten der piezokeramischen Platte angeordneten Friktionselemente zu der Trennebene gleich geneigte Bewegungen ausführen, wodurch auf das zu bewegende Element die Bewegungsenergie übertragen wird.

Außerdem kann der piezoelektrische Oszillator zum Umkehr der Bewegung des zu bewegenden Teils zwei symmetrisch bezüglich der Trennebene angeordnete unsymmetrische Generatoren unsymmetrischer akustischer Welle beinhalten, so dass bei ihrer wahlweisen Ansteuerung der Winkel zwischen der Bewegungsbahn der Friktionselemente und der Trennebene ihr Vorzeichen ändern, wodurch die das zu bewegende Element antreibende Kraft ihre Richtung ändert.

Die Erfindung soll nachstehend anhand von Ausführungsbeispielen sowie unter Zuhilfenahme von Figuren näher erläutert werden.

Hierbei zeigen:
- Fig. 1: die Hauptvariante des erfindungsgemäßen Motors
- Fig. 2: die Konstruktion des Oszillators
- Fig. 3: elektrische Beschaltungen des Oszillators mit der Anregungsquelle
- Fig. 4: den Amplituden-Frequenzgang der elektrischen Eingangsimpedanz des Oszillators
- Fig. 5: die Abhängigkeit der Oszillatorresonanzfrequenz von der Oszillatorlänge
- Fig. 6: die Verformung des Oszillators
- Fig. 7: Amplituden sowie Bewegungsbahnen der Punkte an den langen Stirnseiten des Oszillators
- Fig. 8: eine die Funktionsweise des Motors erklärende Abbildung
- Fig. 9: die Konstruktion des Oszillators der 2. Ordnung
- Fig. 10: elektrische Beschaltungen des Oszillators der 2. Ordnung mit der Anregungsquelle
- Fig. 11: die Konstruktion des Oszillators der 3. Ordnung
- Fig. 12: elektrische Beschaltungen des Oszillators der 3. Ordnung mit der Anregungsquelle und
- Fig. 13: die wichtigsten Kennlinien des erfindungsgemäßen Motors.

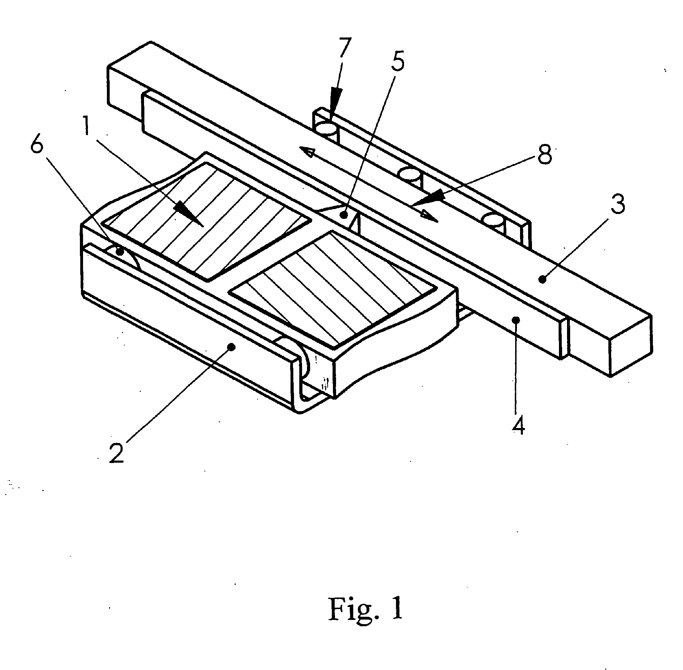

Der erfindungsgemäße piezoelektrische Ultraschallmotor enthält (siehe Fig.1) einen im Gehäuse 2 angeordneten piezoelektrischen Oszillator 1 sowie ein zu bewegendes Element 3 mit einer an ihm befestigten Friktionsleiste 4. Der piezoelektrische Oszillator 1 wird mit dem Friktionselement 5 mit Hilfe der Anpreßelemente 6 elastisch an die Friktionsleiste 4 angepresst. Das zu bewegende Element 3 ist in dem Motorgehäuse 2 auf dem Lager 7 fixiert, so dass es sich in die durch den Pfeil 8 angedeutete Richtung bewegen kann.

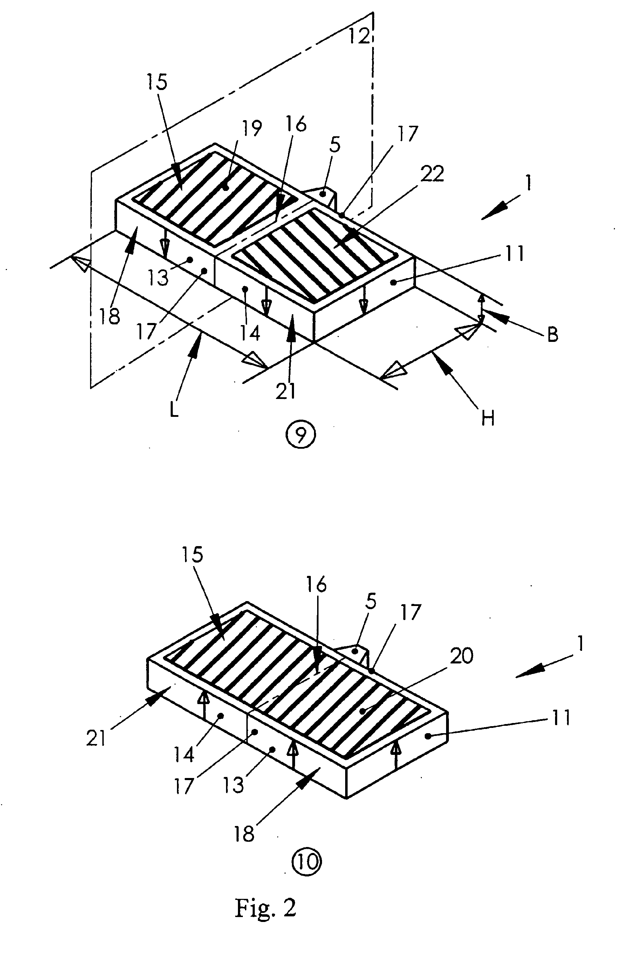

Fig. 2 Pos. 9, 10 zeigen eine Draufsicht bzw. eine Ansicht von unten auf den Oszillator 1. Der Oszillator 1 ist als eine piezoelektrische Platte 11 mit der Länge L, Höhe H sowie der Breite B ausgeführt und ist durch die Trennebene 12 in zwei gleiche Teile 13, 14 geteilt.

Die Trennebene 12 geht durch die Mitte der Oszillatorlänge L und steht senkrecht auf der großen Seite 15 des Oszillators. Der Spur 16 von der Trennebene 12 ist auf dem Oszillator 1 mit Hilfe der Strichlinie gekennzeichnet. Ein oder zwei (nicht im Bild gezeigt) Friktionselemente 5 sind an den langen Stirnseiten 17 der piezoelektrischen Platte 11 in der Mitte der Oszillatorlänge L angeordnet.
In der betrachteten Variante des erfindungsgemäßen Motors beinhaltet das Teil 13 des Oszillators 1 einen unsymmetrischen Generator 18 unsymmetrischer akustischer Wellen. Der unsymmetrische Generator wird durch die Anregungselektrode 19 sowie die gemeinsame Elektrode 20 gebildet, welche an den großen Oberflächen 15 der polarisierten piezoelektrischen Platte 11 angeordnet sind. Die Polarisation der Platte 11 erfolgt senkrecht zu den Elektroden und ist z.B. in Fig. 1 durch Pfeile gekennzeichnet.

Die Unsymmetrie des Generators 18 ist durch seine unsymmetrische Lage in Bezug auf die Trennebene 12 bedingt sowie dadurch, dass bei seiner Anregung im Oszillator eine unsymmetrische zweidimensionale stehende Welle erzeugt wird. Die Welle kann erster, zweiter oder höherer Ordnung sein. Die Länge des Oszillators steht in folgender Beziehung mit der Höhe und der Ordnung der angeregten Welle: L=K*H*n. K ist dabei ein von der Breite bzw. vom Typ der Piezokeramik abhängiger Koeffizient. K≈0,5÷1. n ist die Ordnung der Welle. n=2,3,4....

In dieser Variante des Motors kann das Teil 14 des Oszillators 1 einen zweiten unabhängigen unsymmetrischen Generator 21 unsymmetrischer akustischer Wellen beinhalten mit der Anregungselektrode 22 und der gemeinsamen Elektrode 20.

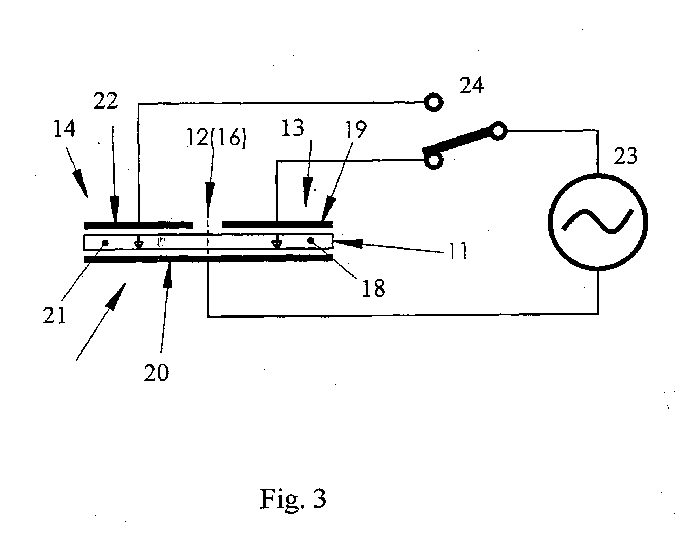

Fig. 3 zeigt eine elektrische Verschaltung der Anregungsquelle 23 mit dem Oszillator 1. Das Schaltbild beinhaltet den Umschalter 24, mit dessen Hilfe die Quelle 23 elektrisch mit dem ersten 18 oder zweiten 21 Generatoren verbunden wird.

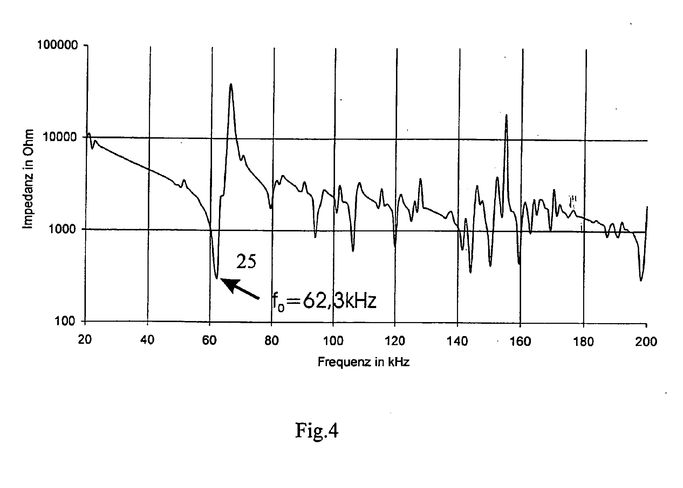

Fig. 4 zeigt den Amplituden-Frequenzgang der elektrischen Eingangsimpedanz des Oszillators 1 mit Abmessungen 60×26×9mm³ gefertigt aus piezoelektrischer Keramik PIC 181 der Firma PI Ceramic GmbH. Die Resonanzstelle 25 kennzeichnet die Resonanzfrequenz f₀, die der unsymmetrischen stehenden Welle erster Ordnung entspricht.

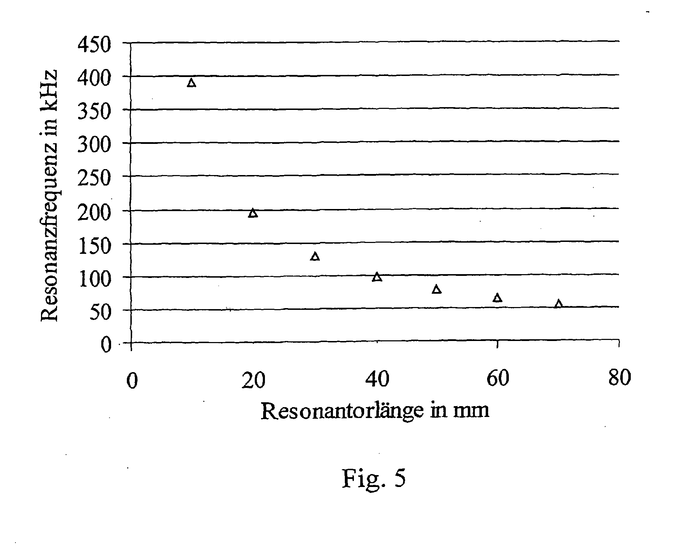

Fig. 5 zeigt eine Abhängigkeit der Oszillatorresonanzfrequenz f₀ (Resonanzstelle 25 in Fig.4) als Funktion der Oszillatorlänge L beim konstanten Verhältnis der Oszillatorlänge zu der Oszillatorhöhe von L/H=2,25 sowie einem konstanten Verhältnis der Oszillatorlänge zu der Oszillatorbreite von L/B=6.

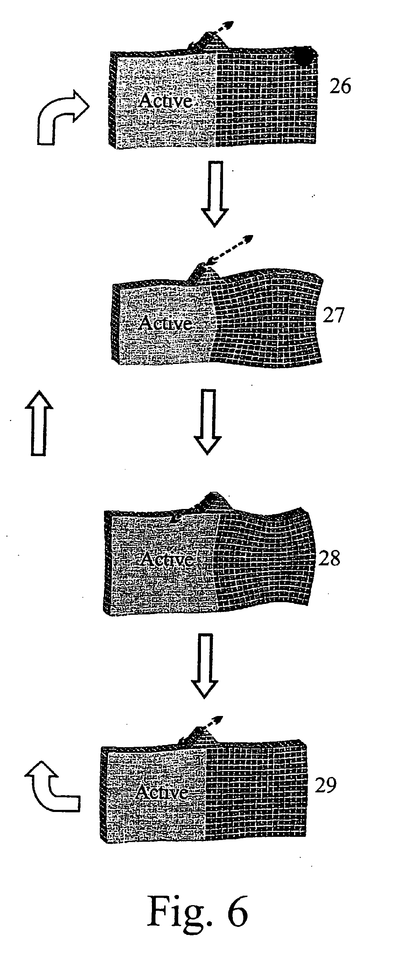

Fig. 6 Pos 26, 27, 28, 29 zeigen Verformungen der Platte 11 des Oszillator 1 bei Anregen einer unsymmetrischen stehenden Welle erster Ordnung.

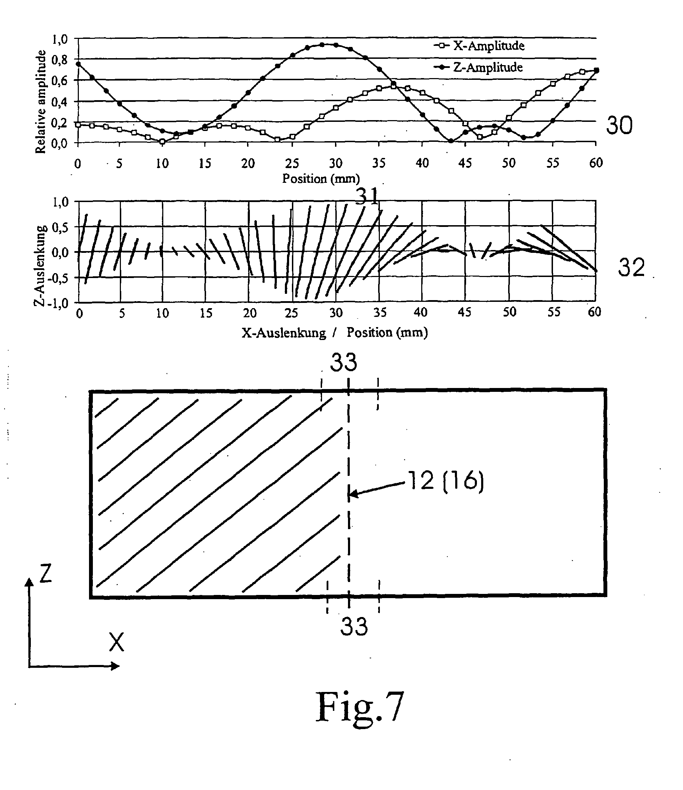

Fig. 7 zeigt Schwingamplituden (Pos.30) sowie die Bewegungsbahnen (Pos.32) der Punkte an der langen Stirnseite 17 der piezoelektrischen Platte 11 bei Anregen der unsymmetrischen stehenden Welle der ersten Ordnung.

Pos. 33 kennzeichnet den Bereich, in dem die Stoßelemente angeordnet werden.

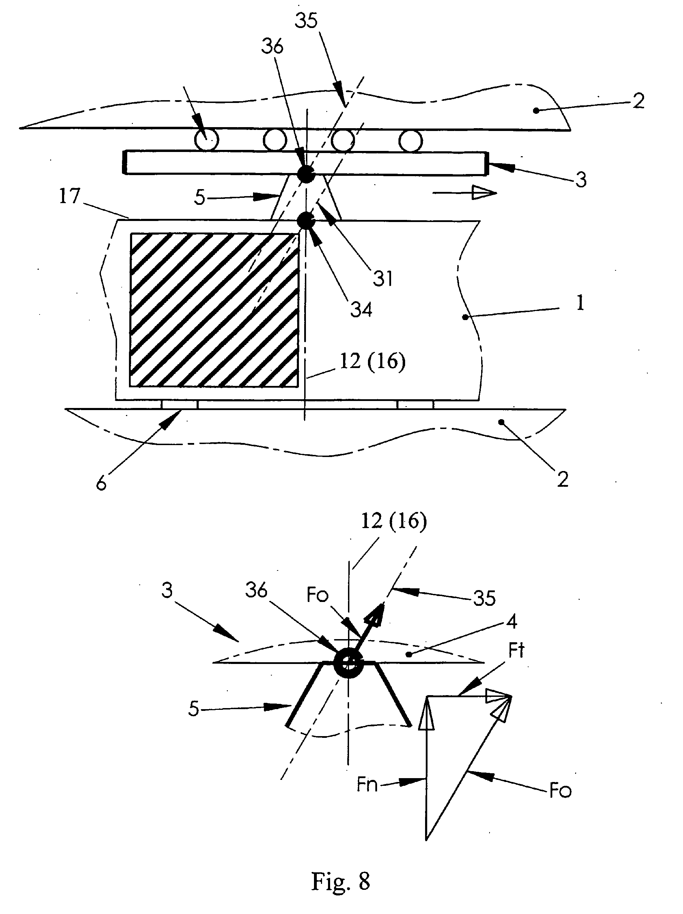

Fig. 8 erklärt die Funktionsweise des erfindungsgemäßen Motors. In diesem Bild ist die Bewegungsbahn 31 des an der langen Stirnseite 17 liegenden Punktes 34 sowie die Bewegungsbahn 35 des Punktes 36 des Friktionselementes 5 dargestellt.

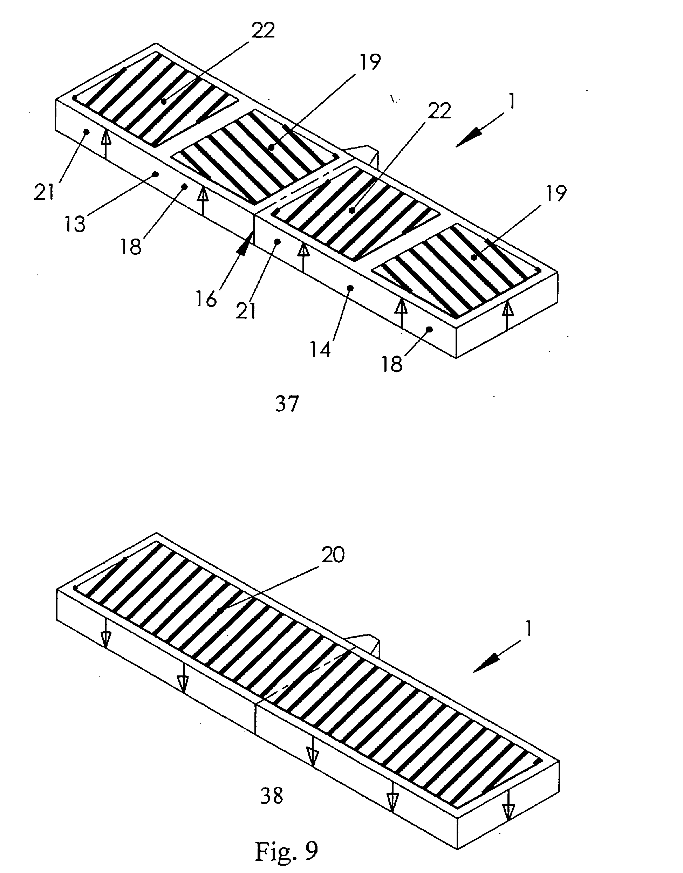

Fig 9 Pos. 37, 38 zeigen einen Oszillator 1 in dem eine unsymmetrische stehende Welle der zweiten Ordnung angeregt wird. In diesem Fall beinhalten die Generatoren 18, 21 jeweils zwei Elektroden 19, 22, die im Abstand L/4 auf den Oszillatorteilen 13, 14 angeordnet sind.

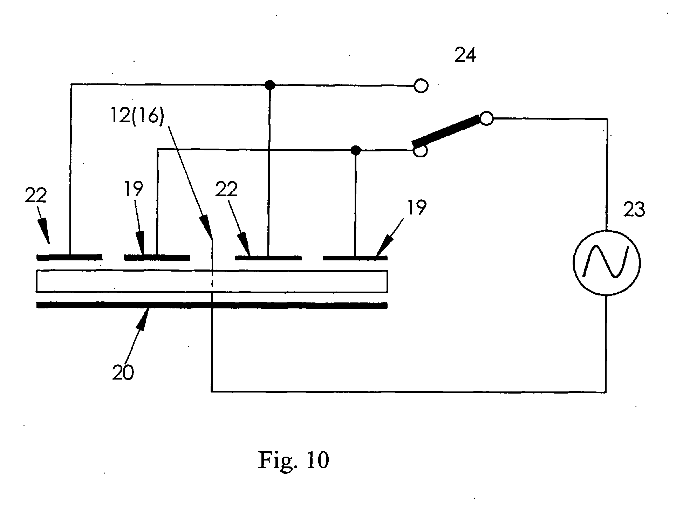

Fig 10 zeigt eine Verschaltung des Oszillators 1 des erfindungsgemäßen Motors mit der elektrischen Anregungsquelle 23.

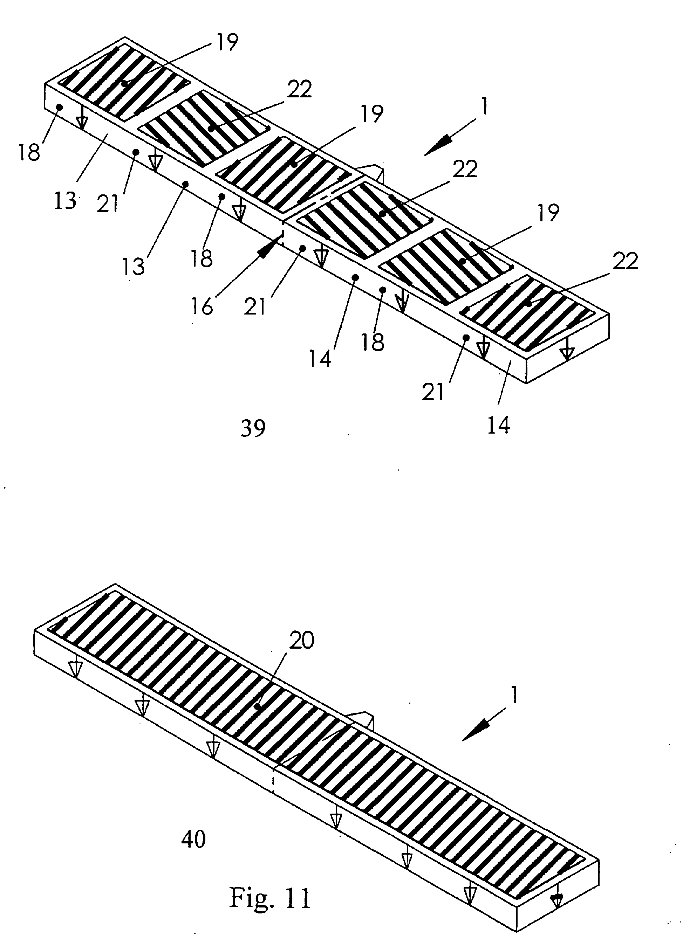

Fig 11, Pos 39, 40 zeigt eine weitere vorteilhafte Ausführungsvariante des erfindungsgemäßen Motors, wobei im Oszillator 1 eine stehende Welle der dritten Ordnung angeregt wird. In diesem Fall beinhalten die Generatoren 18, 21 jeweils drei Anregungselektroden 19, die im Abstand L/6 von einander auf den Oszillatorteilen 13, 14 angeordnet sind.

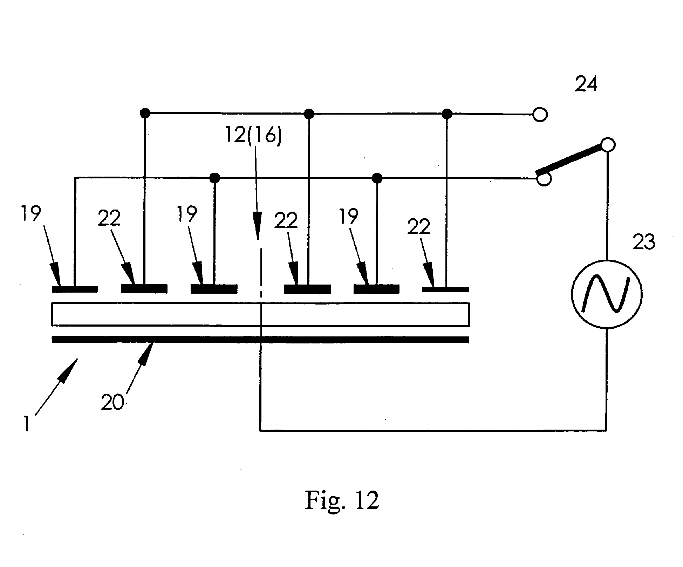

Fig. 12 zeigt die Verschaltung des Oszillators 1 dieser Variante des erfindungsgemäßen Motors mit der elektrischen Anregungsquelle 23.

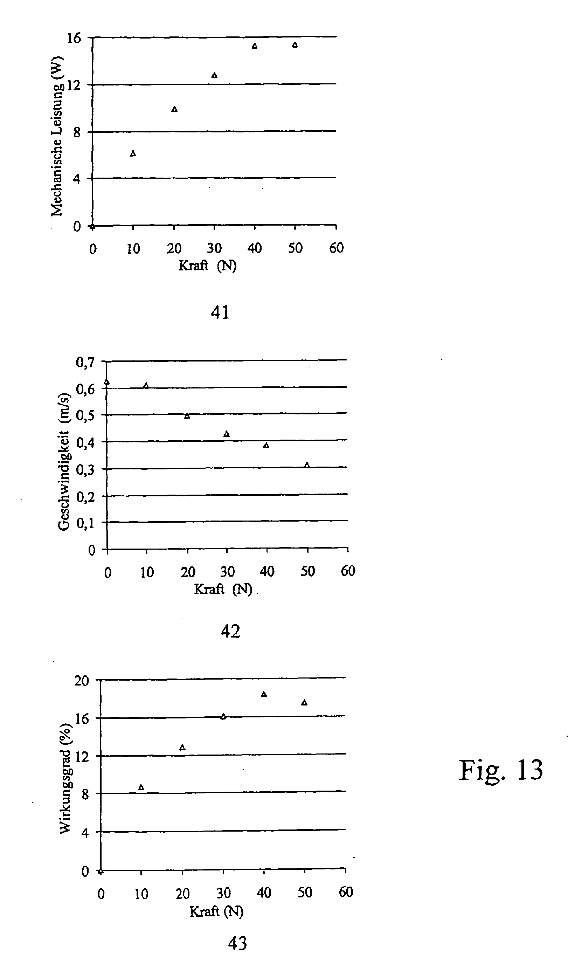

Fig. 13 zeigt die wichtigsten Kennlinien des erfindungsgemäßen Motors mit Oszillatorabmessungen 60×26×9mm³ gefertigt aus der piezoelektrischen Keramik PIC 181 der Firma PI Ceramic GmbH; Pos. 41 zeigt die mechanischen Leistung-Kraft-Kennlinie, Pos. 42 die Geschwindigkeits-Kraft-Kennlinie und Pos. 43 die Wirkungsgrad-Kraft-Kennlie.

Die Funktionsweise wird anhand eines Motors betrachtet, bei dessen Oszillator 1 eine unsymmetrische stehende Welle der ersten Ordnung angeregt wird, d.h. mit einem Oszillator der kleinsten Länge L≈2H.
Zum Betrieb des Motors (Fig.3) wird an die Anregungselektrode 19 sowie die gemeinsame Elektrode 20 von der elektrischen Erregerquelle 23 eine elektrische Wechselspannung angelegt. Die Frequenz f₀ der elektrischen Spannung entspricht dabei der Resonanzfrequenz des Oszillators, bei der die unsymmetrische stehende Welle anregbar ist (siehe Fig.4). Ferner ist f₀ mehr von geometrischen Abmessungen des Oszillators und weniger von dem Typ der piezoelektrischen Keramik abhängig.

Fig. 5 zeigt die experimentell aufgenommene Abhängigkeit der Resonanzfrequenz f₀ von der Oszillatorlänge L bei einem konstanten Verhältnis der Oszillatorlänge L zu der Oszillatorhöhe H von L/H=2,25 sowie bei konstanten Verhältnis der Oszillatorlänge L zu der Oszillatorbreite B von L/B=6 für die aus der piezoelektrischen Keramik PIC 181 gefertigten Oszillatoren dargestellt. Für diese Abhängigkeit stellt das Produkt der Oszillatorlänge mit der Resonanzfrequenz L* f₀ eine konstante Größe dar, die im betrachteten Fall einen Wert von 3911 kHz*mm beträgt. Die Konstante kann zur Bestimmung der Resonanzfrequenz f₀ der unsymmetrischen stehenden Welle für beliebige Abmessungen der piezokeramischen Platte 11 des Oszillators 1 herangezogen werden. Da auf dem in Fig. 4 dargestellten Diagramm in der Nähe der Resonanzfrequenz f₀ sich keine weitere Resonanzen befinden, kann geschlussfolgert werden, dass diese Konstante eindeutig die Frequenz der unsymmetrischen Stehwelle definiert.
Beim Anregen in der Platte 11 des Oszillators 1 der unsymmetrischen zweidimensionalen stehenden Welle verformt sich die Platte, wie es in Fig. 6 gezeigt ist. Die vier Phasen der Verformung (Positionen 26, 27, 28, 29) sind in einem zeitlichen Abstand von einem Viertel der Oszillatorschwingungsperiode dargestellt.
Die unsymmetrische Verformung der Oszillatorplatte 11 äußert sich in der unsymmetrischen Verteilung von Schwingamplituden der an den langen Stirnseiten 17 entlang der Oszillatorlänge liegenden Punkte im Bezug auf die Trennebene 12. In Fig. 7 Pos.30 sind die Schwingamplituden in X- bzw. Z-Richtung dargestellt. Die Punkte bewegen sich entlang der Bahnen 31, die in Pos. 32 dargestellt sind. Die Bewegungsbahnen 31 stellen gerade Linien dar, die mit den Oszillatorstirnseiten 17 je nach Position einen unterschiedlichen Winkel bilden und sie haben eine unsymmetrische Lage in Bezug auf die Trennebene 12. Die Unsymmetrie der Amplitudenverteilung entlang der Oszillatorlänge sowie die daraus resultierende Unsymmetrie in der räumlichen Lage der Bewegungsbahnen ist durch die Unsymmetrie der im Oszillator angeregten stehenden Welle bedingt.

Das im zentralen Bereich 33 angeordnete Friktionselement 5 schwingt entlang einer Geraden 31, (35), die zur Trennebene 12 geneigt ist (siehe Fig.8). Bei seiner Bewegung in Richtung des zu bewegenden Elementes 3 entsteht zwischen dem Friktionselementen 5 und der Friktionsleiste 4 eine Kraft F₀, die in die Normalkomponente Fₙ sowie die Tangentialkomponente Fₜ zerlegbar ist. Die Normalkomponente ist für die Reibkraft verantwortlich, aufgrund derer die Tangentialkomponente Fₜ an das zu bewegende Element 3 übertragen wird. Der Friktionselement 5 überträgt an das zu bewegene Element einen Kraftimpuls, aufgrund dessen dem Letzteren eine Bewegung verliehen wird. Während der Rückwärtsbewegung des Friktionselementes 5 erlischt die Kraft F₀. Die Reibkraft zwischen dem Friktionselementen 5 und dem zu bewegenden Element 3 verschwindet. Das zu bewegende Element 3 bewegt sich bis zu dem nächsten Stoß aufgrund der Trägheit. Die Bewegungsrichtung des zu bewegenden Elementes ist in Fig. 8 mit einem Pfeil gekennzeichnet.
Beim Umschalten des Schalters 24 ändert sich die Lage des aktiven Generators bezüglich der Trennebene 12. Dies führt zu der Spiegelung des Verformungsbildes des Oszillators 1. Im zentralen Bereich 33 des Oszillators ändern sich Amplituden in X-Richtung und in Z-Richtung nicht. Lediglich die Phase zwischen den beiden Komponenten ändert sich um 180°. Der Winkel zwischen den Bewegungsbahnen der Punkte in diesem Bereich und der Trennebene 12 ändert sein Vorzeichen. Dieses führt zum Bewegungsumkehr des zu bewegenden Elementes 3.
Oszillatoren 1 mit Anregung von unsymmetrischen stehenden Wellen zweiter, dritter sowie höheren Ordnungen (siehe Fig. 9, 10, 11, 12) weisen in ihren mittleren Teilen dem Oszillator der Ordnung 1 ähnliche Verformungen auf. Motoren mit dem Einsatz solcher Oszillatoren haben eine analoge Funktionsweise.

Die Fig. 13, Pos 41, 42, 43 zeigt die wichtigsten Kennlinien eines Funktionsmusters des erfindungsgemäßen Ultraschallmotors mit einem Oszillator mit Abmessungen 60×26×9mm³ aus piezoelektrischen Keramik PIC 181. Die maximale Geschwindigkeit des Läufers beträgt 600mm/s, die maximale Kraft 50N und die maximale mechanische Leistung 15 W. Der maximale Wirkungsgrad des Motors beträgt ca. 20%. Die elektrische Anregungsspannung beträgt 200 V_{eff}.
Im Vergleich zu einem nach US-PS 5,616,980 aufgebauten Ultraschallmotor von Typ HR8 der Firma Nanomotion entwickelt das beschriebene Funktionsmuster des Motors eine doppelt so hohe Bewegungsgeschwindigkeit des Läufers sowie eine 1,6 mat größere Kraft. Die Feldstärke im Oszillator ist ca. viermal niedriger als die bei dem Motor der Firma Nanomotion. Das erfindungsgemäße Funktionsmuster enthält nur drei Anschlussleitungen, während die Anzahl bei dem HR8- Motor 40 ist. Dies erhöht z.B. die Zuverlässigkeit des erfindungsgemäßen Motors enorm.
Der erfindungsgemäße Motor ist deutlich einfacher in der Fertigung, woraus wesentlich niedrigere Herstellungskosten resultieren. Außerdem ist der Motor konstruktiv deutlich einfacher zu realisieren.

### Bezugszeichenliste

- 1.: piezoelektrischer Oszillator
- 2.: Gehäuse
- 3.: zu bewegendes Element (Läufer)
- 4.: Friktionsleiste
- 5.: Friktionselement
- 6.: Anpresselemente
- 7.: Lager
- 8.: Bewegungsrichtungspfeil
- 9.: Draufsicht auf den Oszillator der Ordnung 1
- 10.: Ansicht von unten auf den Oszillator der Ordnung 1
- 11.: piezoelektrische Platte des Oszillators 1
- 12.: Trennebene
- 13.: Teil des Oszillators 1
- 14.: Teil des Oszillators 1
- 15.: große Oberfläche des Oszillators 1
- 16.: Spur der Trennebene 12
- 17.: langen Stirnseiten
- 18.: unabhängiger unsymmetrischer Generator unsymmetrischer akustischer Stehwelle
- 19.: Anregungselektrode des Generators 18
- 20.: gemeinsame Elektrode
- 21.: zweiter unsymmetrischer Generator unsymmetrischer akustischer Stehwelle
- 22.: Anregungselektrode des Generators 21
- 23.: Anregungsquelle des Oszillators 1
- 24.: Umschalter
- 25.: Resonanzstelle
- 26.: Verformung des Oszillators
- 30.: Amplitudenverteilung der Punkte an der langen Stirnseite 17 der Platte 11
- 31.: Bewegungsbahn eines Punktes an der langen Stirnseite 17 der Platte 11
- 32.: Bewegungsbahnen der Punkte an der langen Stirnseite 17 der Platte 11
- 33.: Bereich des Stoßelementes 5
- 34.: Punkte an der Stirnseite 17 der Platte 11
- 35.: Bewegungsbahn des Punktes 36 an dem Friktionselement 5
- 36.: Punkt des Friktionselementes 5
- 37.: Draufsicht auf den Oszillator 1 der Ordnung 2
- 38.: Ansicht von unten auf den Oszillator 1 der Ordnung 2
- 39-: Draufsicht auf den Oszillator 1 der Ordnung 3
- 40.: Ansicht von unten auf den Oszillator 1 der Ordnung 3
- 41.: mechanische Leistungs-Kraft Kennlinie
- 42.: Geschwindigkeits-Kraft Kennlinie
- 43.: Wirkungsgrad-Kraft Kennlinie

## Patentansprüche

1. Piezoelektrischer Ultraschallmotor mit einem Oszillator (1) in Form einer piezoelektrischen Platte (11) der Länge L, der Höhe H und Breite B sowie mit einem am Oszillator (1) angeordneten und elastisch an eine Friktionsoberfläche eines zu bewegenden Elements (3) angepressten Friktionselement (5),
**dadurch gekennzeichnet, dass** die piezoelektrische Platte (11) durch eine senkrecht zu den großen Oberflächen liegende Trennebene (12) in zwei gleiche Teile (13, 14) geteilt ist, wobei mindestens eines von diesen Teilen einen unsymmetrischen Generator (18, 21) einer unsymmetrischen akustischen Stehwelle beinhaltet, der bei seiner Ansteuerung eine unsymmetrische zweidimensionale stehende Welle mit der Resonanzfrequenz f₀ erzeugt, und die den Oszillator (1) derartig deformiert, dass das an einer langen Stirnseite (17) der piezoelektrischen Platte (11) angeordnete Friktionselement (5) eine Bewegung ausführt, die zu der langen Stirnseite (17) geneigt ist, und aufgrund besagter Bewegung auf das zu bewegende Element (3) ein dieses antreibender Kraftimpuls übertragen wird, wobei das Produkt der Oszillatorlänge L und der Resonanzfrequenz f₀ bei einem konstanten Verhältnis der Oszillatorlänge L zu der Oszillatorhöhe H sowie einem konstanten Verhältnis der Oszillatorlänge L zu der Oszillatorbreite B eine konstante Größe ist.

2. Piezoelektrischer Ultraschallmotor nach Anspruch 1,
**dadurch gekennzeichnet, dass** das Verhältnis der Oszillatorlänge L zu der Oszillatorhöhe H gleich 2,25 ist und das Verhältnis der Oszillatorlänge L zu der Oszillatorbreite B gleich 6 ist und das Produkt der Resonanzfrequenz f₀ und der Oszillatorlänge L gleich 3911KHz · mm ist.

3. Piezoelektrischer Ultraschallmotor nach Anspruch 1 oder 2,
dadurch gekennzichnet, dass der piezoelektrische Oszillator (1) für die Umkehr der Bewegung des zu bewegenden Elements (3) zwei symmetrisch bezüglich der Trennebene (12) angeordnete unsymmetrische Generatoren (18, 21) der unsymmetrischen akustischen stehenden Welle beinhaltet, so dass bei deren wahlweiser Ansteuerung der Winkel zwischen der Trennebene (12) und der Bewegungsbahn des Friktionselementes (5) sein Vorzeichen ändert, wodurch die das zu bewegende Element (3) antreibende Kraft ihre Richtung ändert.

## Claims

1. Piezoelectric ultrasound motor comprising an oscillator (1) in the form of a piezoelectric plate (11) of length L, height H and width B, and comprising a friction element (5) arranged at the oscillator (1) and elastically pressed against a friction surface of an element (3) to be moved,
**characterized in that**
the piezoelectric plate (11) is divided into two identical parts (13, 14) by a dividing plane (12) that extends perpendicular to the large surfaces, wherein at least one of these parts includes an asymmetrical generator (18, 21) of an asymmetrical standing wave, the asymmetrical generator (18, 21), when activated, generating an asymmetrical two-dimensional standing wave having a resonance frequency f₀ that deforms the oscillator (1) such that the friction element (5) arranged at a long end face (17) of the piezoelectric plate (11) makes a movement that is inclined relative to the long end face (17), and, on account of said movement, a force impulse is transferred to the element (3) to be moved, driving same, wherein the product of the oscillator length L and the resonance frequency f₀ is a constant value at a constant ratio of oscillator length L to oscillator height H and at a constant ratio of oscillator length L to oscillator width B.

2. Piezoelectric ultrasound motor according to claim 1,
**characterized in that**
the ratio of oscillator length L to oscillator height H is equal to 2.25 and the ratio of oscillator length L to oscillator width B is equal to 6 and the product of the resonance frequency f₀ and the oscillator length L is equal to 3911 KHz · mm.

3. Piezoelectric ultrasound motor according to claim 1 or 2,
**characterized in that**
for the reversal of the movement of the element (3) to be moved, the piezoelectric oscillator (1) includes two asymmetrical generators (18, 21) of the asymmetrical acoustic standing wave, the asymmetrical generators (18, 21) being arranged symmetrically with respect to the dividing plane (12), so that upon the selective activation thereof the angle between the dividing plane (12) and the movement path of the friction element (5) changes its sign, which causes the force that drives the element (3) to be moved to change its direction.

## Revendications

1. Moteur piézoélectrique à ultrasons comprenant un oscillateur (1) sous la forme d'une plaque piézoélectrique (11) de longueur L, de hauteur H et de largeur B, et comprenant un élément à friction (5) agencé contre l'oscillateur (1) et pressé élastiquement contre une surface de friction d'un élément (3) à déplacer,
**caractérisé en ce que** la plaque piézoélectrique (11) est subdivisée par un plan de séparation (12) perpendiculaire aux grandes surfaces, en deux parties égales (13, 14), dans lesquelles l'une au moins de ces parties contient un générateur asymétrique (18, 21) pour une onde acoustique stationnaire asymétrique qui, lors de son pilotage, engendre une onde stationnaire bidimensionnelle asymétrique avec la fréquence de résonance f₀, et qui déforme l'oscillateur (1) de telle manière que l'élément à friction (5) agencé contre une face frontale longue (17) de la plaque piézoélectrique (11) exécute un mouvement qui est incliné par rapport à la face frontale longue (17) et en raison dudit mouvement, une impulsion de force qui entraîne l'élément mobile (3) est transmise à celui-ci, et le produit de la longueur L de l'oscillateur et de la fréquence de résonance f₀ est une grandeur constante en cas d'un rapport constant de la longueur L de l'oscillateur sur la hauteur H de l'oscillateur, ainsi que d'un rapport constant de la longueur L de l'oscillateur sur la largeur B de l'oscillateur.

2. Moteur piézoélectrique à ultrasons selon la revendication 1,
**caractérisé en ce que** le rapport de la longueur L de l'oscillateur sur la hauteur H de l'oscillateur est égal à 2,25, et le rapport de la longueur L de l'oscillateur sur la largeur B de l'oscillateur est égal à 6, et le produit de la fréquence de résonance f₀ et de la longueur L de l'oscillateur est égal à 3911 kHz · mm.

3. Moteur piézoélectrique à ultrasons selon la revendication 1 ou 2,
**caractérisé en ce que** l'oscillateur piézoélectrique (1) contient, pour le renversement du mouvement de l'élément à déplacer (3), deux générateurs asymétriques (18, 21) agencés symétriquement par rapport au plan de séparation (12) pour l'onde acoustique stationnaire asymétrique, de sorte que lors de leur pilotage sélectif, l'angle entre le plan de séparation (12) et le trajet de déplacement de l'élément à friction (5) change de signe, en raison de quoi la force qui entraîne l'élément mobile (3) change de direction.
